# EUROPEAN PATENT APPLICATION

(11) **EP 1 328 075 A2**
(43) Date of publication of application: **16.07.2003**
(21) Application number: 03000434.5
(22) Date of filing: 10.01.2003
(51) Int. Cl.: H04B 7/185

(54) **Redundancy switching for satellite payload**

(30) Priority: 11.01.2002 US 44283
(71) Applicant: TRW INC., Redondo Beach, CA 90278 (US)
(72) Inventor: DiCamillo, Nicholas F., Torrance, CA 90503 (US); Franzen, Daniel R., Hermosa Beach, CA 90278 (US); Lane, Daniel R., Santa Monica, CA 90405 (US); Park, Young C., Manhattan Beach, CA 90266 (US)
(74) Representative: Schmidt, Steffen J., Dipl.-Ing.

(57) **Abstract**

A redundancy network is provided that may include a first unit having first unit primary components and first unit redundant components, and a second unit (coupled to the first unit) having second unit primary components and second unit redundant components. A signal may pass through the first unit primary components and through the second unit primary components based on a first control signal and pass through the first unit redundant components and through the second unit redundant components based on a second control signal.

## Description

### BACKGROUND OF THE INVENTION

### 1. Field of the Invention

The present invention relates to redundancy switching. More particularly, the present invention relates to redundancy switching for spacecraft such as satellites.

### 2. Discussion of the Related Art

Satellites contain a large number of components. To ensure longetivity of the satellite, many components (hereafter also called primary components within the satellite) also have corresponding redundant components. When one of the primary components fails or is in danger of failing, a redundant component may be switched into a signal path to ensure proper signal propagation. It is desirable to limit the number of control signals (such as power control signals) to switch in and switch out redundant components.

### BRIEF SUMMARY OF THE INVENTION

Embodiments of the present invention may provide a redundancy network for a satellite that includes a first hardware unit having primary components and redundant components, and a second hardware unit (coupled in series to the first hardware unit) and having primary components and redundant components. Communication signals may pass through the primary components of the first hardware unit and through the primary components of the second hardware unit based on a first control signal and/or communication signals may pass through the redundant components of the first hardware unit and through the redundant components of the second hardware unit based on a second control signal.

Embodiments of the present invention may also include a third hardware unit having primary components and redundant components. A fourth hardware unit may be coupled in series to the third hardware unit and have primary components and redundant components. Communication signals may pass through the primary components of the third hardware unit and through the primary components of the fourth hardware unit based on a third control signal and the communication signals may pass through the redundant components of the third hardware unit and through the redundant components of the fourth hardware unit based on a fourth control signal.

A power control unit may apply the second control signal to the first unit and may apply the second control signal to the second unit upon failure of the primary components in either the first hardware unit or the second hardware unit.

Other embodiments, objects, advantages and salient features of the present invention will become apparent from the detailed description taken in conjunction with the annexed drawings which disclose preferred embodiments of the present invention.

### BRIEF DESCRIPTION OF THE DRAWINGS

The foregoing and a better understanding of the present invention will become apparent from the following detailed descriptions of example embodiments and the claims when read in connection with the accompanying drawings, all forming a part of the disclosure of this invention. While the foregoing and following written and illustrated disclosure focuses on disclosing example embodiments of the invention, it should be clearly understood that the same is by way of illustration and example only and the invention is not limited thereto.

The following represents brief descriptions of the drawings in which like reference numerals represent like elements and wherein:

FIG. 1 is a block diagram illustrating a satellite payload according to an example embodiment of the present invention;

FIG. 2 illustrates two hardware units;

FIG. 3 illustrates a plurality of hardware units and one method of redundancy switching;

FIG. 4 illustrates a plurality of hardware units and one method of redundancy switching; and

FIG. 5 illustrates a plurality of hardware units and a method of redundancy switching according to an example embodiment of the present invention.

### DETAILED DESCRIPTION OF THE INVENTION

In the following detailed description, like reference numerals and characters may be used to designate identical, corresponding, or similar components in differing drawing figures. Furthermore, in the detailed description to follow, examples may be given, although the present invention is not limited thereto.

Before describing details of embodiments of the present invention, a brief overview of an exemplary satellite payload architecture will be provided. The exemplary satellite payload architecture to be described is capable of receiving high frequency uplink beams at a plurality of receive antennas, converting the higher frequency to a lower frequency for switching and filtering of channels, converting the lower frequency signals to a higher frequency, and distributing the high power signals to one of the plurality of transmit antennas. As one example, the satellite may be a communications satellite for use with broadband communications such as for the Internet. The satellite may include numerous antenna structures such as disclosed in U.S. Patent 6,236,375, the subject matter of which is incorporated herein by reference. Each antenna may be an offset Cassegrain antenna having a subreflector, a main reflector and a separate feed array. Other types of satellites and antenna structures are also within the scope of the present invention.

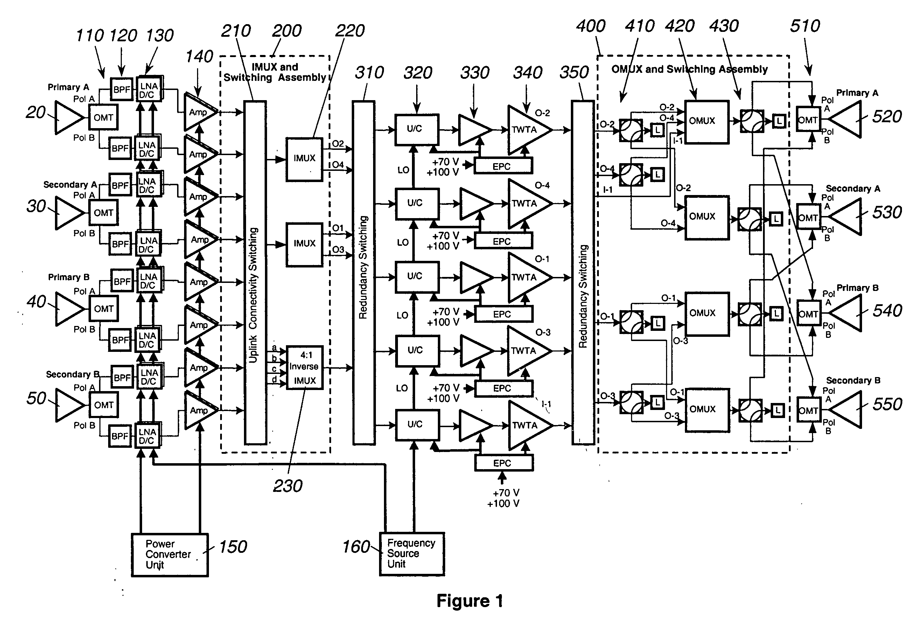

FIG. 1 is a block diagram illustrating electronics in a payload for one beam group of a multi-beam satellite according to an example embodiment of the present invention. Other embodiments and configurations are also within the scope of the present invention. As one example, the satellite may include eight antenna structures for receiving and transmitting eight beam groups.

FIG. 1 shows a first dual-polarization antenna 20, a second dual-polarization antenna 30, a third dual-polarization antenna 40 and a fourth dual-polarization antenna 50 each to receive uplink beams from Earth in a well-known manner. Upon receipt of the uplink signals (such as broadband communication signals) at the antennas, the received signals pass through four ortho-mode transducers (OMT) 110 to eight band pass filters (BPF) 120. The filtered signals may pass to eight low noise amplifier downconverters (LNA D/C) 130 that convert the received and filtered signals from a higher frequency (such as approximately 30 GHz in the Ka-band) to a lower frequency (such as approximately 4 or 5 GHz in the C-band).

The lower frequency C-band signals may then be amplified by eight C-band utility amplifiers 140 and proceed to an input multiplexer (IMUX) and switching assembly 200. The IMUX and switching assembly 200 may include an uplink connectivity switching network 210, which may be a power dividing switching network. Signals output from the uplink connectivity switching network 210 may be input to either one of the two outbound IMUXes 220 or to the 4:1 inverse IMUX 230. The IMUXes 220 output signals along forward channels O1, 02, 03 and 04 to a C-band redundancy switching network 310. The 4:1 inverse IMUX 230 outputs signals along return channel I1 to the C-band redundancy switching network 310.

The C-band redundancy switching network 310 outputs signals to five up converters (U/C) 320. The U/Cs 320 convert the lower frequency signals to higher K-band frequency signals (such as approximately 20 GHz) that will be used for transmission back to the Earth. The higher frequency K-band signals may then pass through five K-band linearizer/channel amplifiers 330 and five TWTAs (TWTA) 340. The five TWTAs 340 are high power amplifiers that supply the transmit RF power to achieve the downlink transmission. The five TWTAs 340 output four high power outbound signals O-1, O-2, O-3, O-4 to the users and one inbound signal I-1 to the gateway. The K-band redundancy switching network 350 provides the signals I-1, O-1, O-2, O-3 and O-4 to an output multiplexer (OMUX) and switching assembly 400.

The OMUX and switching assembly 400 may include mechanical switches 410 that couple the signals I-1, O-1, O-2, O-3 and O-4 to multiplexers (OMUX) 420. The signals pass through the OMUXes 420 and are appropriately distributed to mechanical switches 430. The switches 430 distribute the signals to one of the downlink OMTs 510 and the corresponding downlink antenna such as a first dual-polarization downlink antenna 520, a second dual-polarization downlink antenna 530, a third dual-polarization downlink antenna 540 and a fourth dual-polarization downlink antenna 550.

A power converter unit 150 may also be provided to supply DC power to the LNA D/Cs 130 and the C-band utility amplifiers 140. Additionally, one centralized frequency source unit 160 supplies a local oscillation (LO) signal to the LNA D/Cs 130 and to the U/Cs 320. The power converter unit 150 and centralized frequency source unit 160 are shared across all beam groups of the satellite.

Embodiments of the present invention are applicable to a redundancy network such as on the satellite. The redundancy network may be provided within a communications payload of a satellite. For example, the redundancy network to be described below may relate to alternative implementations of the redundancy switching network 310 and the redundancy switching network 350, including the hardware units 320, 330 and 340 shown in FIG. 1. The redundancy network may include a first hardware unit having primary components provided on a primary path between an input terminal and an output terminal and redundant components provided on a redundant path between the input terminal and the output terminal. A second hardware unit may be coupled in series with the first hardware unit. The second hardware unit may have primary components provided on a primary path between an input terminal and an output terminal and redundant components provided on a redundant path between the input terminal and the output terminal. A power control unit may apply a signal to the first hardware unit and to the second hardware unit to utilize the redundant components of the first hardware unit and the second hardware unit. The power control unit may apply the signal to the first hardware unit and to the second hardware unit when a failure occurs to any one of the primary components of the first hardware unit or the second hardware unit.

In order to fully appreciate benefits of embodiments of the present invention, disadvantageous arrangements will first be described with respect to redundancy networks. In satellite payload hardware, there is a need for power control signals to more efficiently switch out failed hardware units and switch in working redundant hardware units. In disadvantageous arrangements, multiple control lines may be needed to switch in/out redundant components of the hardware units.

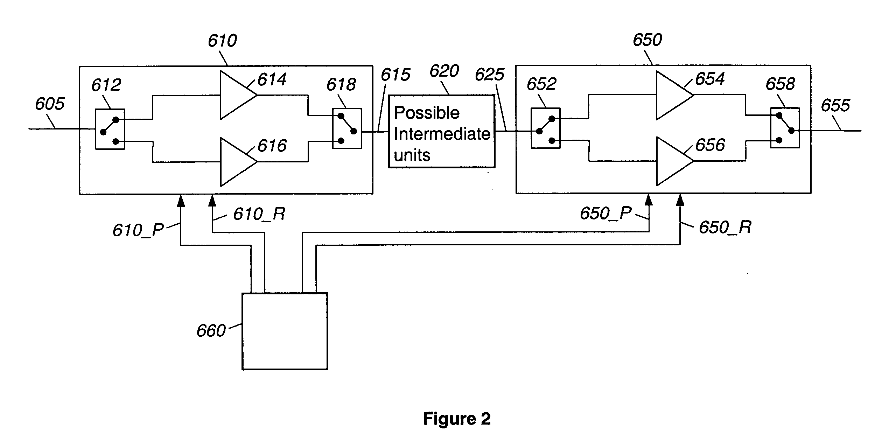

FIG. 2 illustrates two series coupled hardware units that may be provided within a satellite communications payload. In particular, the communications payload may include a first hardware unit 610 and a second hardware unit 650 that may or may not be separated by intermediate hardware units 620. As one example, the first hardware unit 610 may correspond to one of the LNA D/Cs 130 whereas the second hardware unit may correspond to one of the C-band utility amplifiers 140. Other examples of the hardware units are also within the scope of the present invention. The first hardware unit 610 may perform at least one function to the communications signals and the second hardware unit 650 may perform a separate function to the communications signals even though the hardware units are coupled in series. The first hardware unit 610 and the second hardware unit 650 may be separated by a considerable distance such as upwards of forty feet. As is customary in satellites, the first hardware unit 610 may include primary components and redundant components. The redundant components may be utilized when any of the primary components fail. Hardware units within the satellite payload may include appropriate circuitry and mechanisms to switch in redundant components when primary components fail.

More specifically, the first hardware unit 610 includes a first switch 612 and a second switch 618 that operate to switch between primary components 614 and redundant components 616. The redundant components 616 may be switched in when any one of the primary components 614 fail. The second hardware unit 650 includes a first switch 652 and a second switch 658 that operate to switch between primary components 654 and redundant components 656. The redundant components 656 may be switched in when any one of the primary components 654 fail.

When properly functioning and all components work, signals (such as communications signals) are input to the first hardware unit 610 at an input terminal along a signal line 605. The signals may pass through the switch 612, through the primary components 614 and through the switch 618 to an output terminal of the first hardware unit 610. This path is the primary path of the first hardware unit 610. The signals may then travel along a signal line 615 to intermediate units 620. The intermediate units 620 may relate to signal processing of the communications signals, for example. The signals may then pass along a signal line 625 to an input terminal of the second hardware unit 650. As shown, the second hardware unit 650 is coupled in series with the first hardware unit 610. The signals may pass through a switch 652, through primary components 654 and through the switch 658 to an output terminal of the second hardware unit 650. This path is the primary path of the second hardware unit 650. The signals may pass out of an output terminal of the second hardware unit 650 along a signal line 655.

Operation of the switches 612 and 618 may be based on power control signals that are applied from a power control unit 660 to the first hardware unit 610. That is, the power control unit 660 may apply signals (such as signal 610_P) to operate the switches 612 and 618 such that signals propagate along the primary path through the primary components 614. The power control unit 660 may also contain mechanisms to determine (or receive an indication of) a primary component failure on the first hardware unit 610. The power control unit 660 may then switch out the primary components and switch in the redundant components 616 in the first hardware unit 610. In this situation, the power control unit 660 may apply a signal (such as signal 610_R) to operate the switches 612 and 618 such that signals propagate from the input terminal and along the redundant path (through the redundant components 616) to the output terminal. That is, the signals may pass from the input terminal, through the switch 612, through the redundant components 616, and through the switch 618 to the output terminal of the first hardware unit 610. Similarly, the power control unit 660 may also contain mechanisms to determine (or receive an indication of) a primary component failure on the second hardware unit 650. The power control unit 660 may switch out the primary components 654 and switch in redundant components 656 in the second hardware unit 650. In this situation, the power control unit 660 may apply a signal (such as signal 650_R) to operate the switches 652 and 658 such that signals propagate from the input terminal and along the redundant path (through the redundant components 656) to the output terminal. That is, the signals may pass from the input terminal, through the switch 652, through the redundant components 656, and through the switch 658 to the output terminal of the second hardware unit 650.

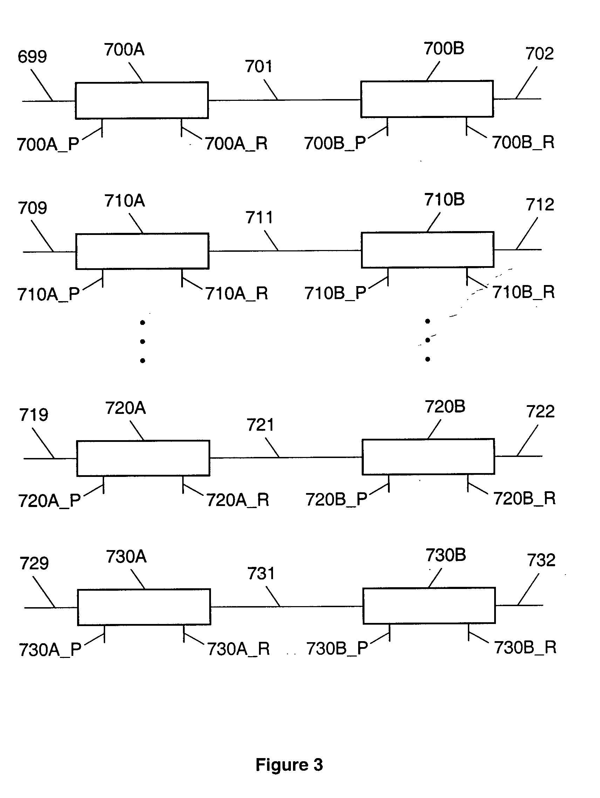

Figs. 3-5 each illustrate a plurality of hardware units coupled in parallel and in series. While the general structure and coupling of the hardware units may appear similar, each of the these figures illustrates a different method of redundancy switching. Each of the different methods of redundancy switching will be separately discussed.

More particularly, each of Figs. 3-5 illustrates parallel hardware units 700A, 710A, 720A and 730A each of which may be similar to the first hardware unit 610 shown in FIG. 2. That is, each of the hardware units 700A, 710A, 720A and 730A may perform a substantially similar function. Figs. 3-5 also illustrate hardware units 700B, 710B, 720B and 730B each of which may be similar to the second hardware unit 650 shown in FIG. 2. Each of the hardware units 700B, 710B, 720B and 730B may perform a substantially similar function. Internal components within each of the hardware units are not shown for ease of illustration. Each of the hardware units may include primary components and redundant components in a similar manner as in FIG. 2. One skilled in the art would understand that the primary components and the redundant components may be arranged in different manners.

In Figs. 3-5, signals (such as communications signals) may arrive along a signal line (or signal lines) 699 at an input terminal of a first hardware unit 700A. After passing through the first hardware unit 700A and having the desired function performed, the signals may propagate from an output terminal of the first hardware unit 700A along a signal line 701 to a second hardware unit 700B. For ease of illustration, the intermediate units 620 are not shown in each of Figs. 3-5. The signals may be input at an input terminal of the second hardware unit 700B. After passing through the second hardware unit 700B and having the desired function performed, the signals may propagate from an output terminal of the second hardware unit 700B along a signal line 702.

Each of the remaining hardware units may operate in a similar manner as discussed above for the first hardware unit 700A and the second hardware unit 700B. The structure and coupling of the remaining hardware units will be briefly discussed since this structure of parallel and series hardware units may be used in embodiments of the present invention.

Signals may arrive along a signal line (or signal lines) 709 at an input terminal of a first hardware unit 710A. After passing through the first hardware unit 710A and having the desired function performed, the signals may propagate from an output terminal of the first hardware unit 710A along a signal line 711 to an input terminal of a second hardware unit 710B. After passing through the second hardware unit 710B and having the desired function performed, the signals may propagate from an output terminal of the second hardware unit 710B along a signal line 712.

Additionally, signals may arrive along a signal line (or signal lines) 719 at an input terminal of a first hardware unit 720A. After passing through the first hardware unit 720A and having the desired function performed, the signals may propagate from an output terminal of the first hardware unit 720A along a signal line 721 to an input terminal of a second hardware unit 720B. After passing through the second hardware unit 720B and having the desired function performed, the signals may propagate from an output terminal of the second hardware unit 720B along a signal line 722.

Still further, signals may arrive along a signal line (or signal lines) 729 at an input terminal of a first hardware unit 730A. After passing through the first hardware unit 730A and having the desired function performed, the signals may propagate from an output terminal of the first hardware unit 730A along a signal line 731 to an input terminal of a second hardware unit 730B. After passing through the second hardware unit 730B and having the desired function performed, the signals may propagate from an output terminal of the second hardware unit 730B along a signal line 732.

As discussed above with respect to FIG. 2, each hardware unit may receive separate power control signals to control whether communications signals received at an input terminal pass along (or through) either primary components or redundant components for each respective hardware unit. FIG. 3 illustrates an arrangement in which each of the hardware units may be separately controlled based on separate power control signals. These power control signals control whether the signals propagate along a primary path or a redundant path. For example, the first hardware unit 700A may receive a signal 700A_P (representing primary components) and/or a signal 700A_R (representing redundant components). The power control unit 660 (FIG. 2) may control which signal is applied to the first hardware unit 700A and/or a state of each of the signals 700A_P and 700A_R. The signal 700A_P may control switches (similar to the switches 612 and 618) or other components such that signals propagate from an input terminal along a primary path (through primary components) and to an output terminal of the first hardware unit 700A. On the other hand, the signal 700A_R may control switches (similar to the switches 612 and 618) or other components such that signals propagate from an input terminal along a redundant path (through redundant components) to an output terminal of the first hardware unit 700A.

The second hardware unit 700B may receive a signal 700B_P (representing primary components) and/or a signal 700B_R (representing redundant components). The power control unit 660 (FIG. 2) may control which signal is applied to the second hardware unit 700B and/or a state of each of the signals 700B_P and 700B_R. The signal 700B_P may control switches (similar to the switches 652 and 658) or other components such that signals propagate from an input terminal along a primary path (through primary components) and to an output terminal of the second hardware unit 700B. On the other hand, the signal 700B_R may control switches (similar to the switches 652 and 658) or other components such that signals propagate from an input terminal along a redundant path (through redundant components) and to an output terminal of the second hardware unit 700B.

Each of the remaining hardware units 710A, 710B, 720A, 720B, 730A and 730B may also be separately controlled by the power control unit 660. That is, the first hardware unit 710A may receive signals 710A_P (for primary components) and 710A_R (for redundant components), the first hardware unit 720A may receive signals 720A_P (for primary components) and 720A_R (for redundant components), and the first hardware unit 730A may receive signals 730A_P (for primary components) and 730A_R (for redundant components). Similarly, the second hardware unit 710B may receive signals 710B_P (for primary components) and 710B_R (for redundant components), the second hardware unit 720B may receive signals 720B_P (for primary components) and 720B_R (for redundant components), and the second hardware unit 730B may receive signals 730B_P (for primary components) and 730B_R (for redundant components). Thus, in the FIG. 3 arrangement, each hardware unit receives separate power control signals. This results in an extremely large number of power control lines.

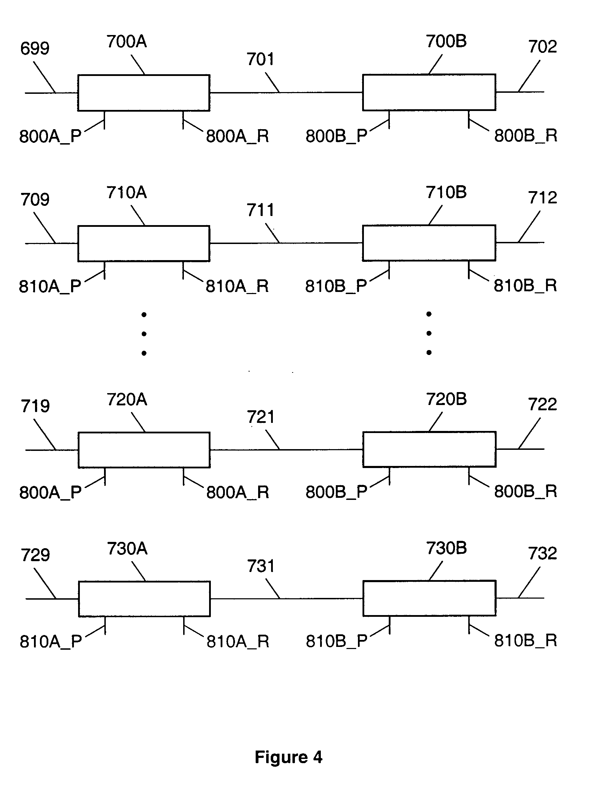

FIG. 4 illustrates an arrangement in which two similarly functioning hardware units may be controlled together (i.e., simultaneously) based on one set of power control signals. The similarly functioning hardware units may be in parallel. More specifically, FIG. 4 illustrates that the first hardware unit 700A and the first hardware unit 720A may both receive signals 800A_P (for primary components) and 800A_R (for redundant components). Similarly, the first hardware unit 710A and the first hardware unit 730A may both receive signals 810A_P (for primary components) and 810A_R (for redundant components). FIG. 4 also illustrates that the second hardware unit 700B and the second hardware unit 720B may both receive signals 800B_P (for primary components) and 800B_R (for redundant components). The second hardware unit 710B and the second hardware unit 730B may both receive signals 810B_P (for primary components) and 810B_R (for redundant components).

In the FIG. 4 arrangement, the power control unit 660 operates to apply the signal 800A_R when any component in either the first hardware unit 700A or the first hardware unit 720A fails or is in danger of failing. The power control unit 660 also operates to apply the signal 810A_R when any component in either the first hardware unit 710A or the first hardware unit 730A fails or is in danger of failing. The power control unit 660 operates to apply the signal 800B_R when any component in either the second hardware unit 700B or the second hardware unit 720B fails or is in danger of failing. Additionally, the power control unit 660 operates to apply the signal 810B_R when any component in either the second hardware unit 710B or the second hardware unit 730B fails or is in danger of failing.

Because the power control unit 660 provides one control signal to two parallel hardware units (such as the first hardware unit 700A and the first hardware unit 720B), a problem may occur when one of the two hardware units switches to redundant components. For example, if a failure occurs with primary components of the first hardware unit 720A, then the power control unit 660 may apply the signal 800A_R to switch to redundant components in both the first hardware unit 700A and the first hardware unit 720A. However, the primary components within the first hardware unit 700A are still operable. By switching to the redundant components in the first hardware unit 700A, the signal propagation path will be interrupted momentarily although no failure has occurred in the signal path of the first hardware unit 700A and the second hardware unit 700B. This interruption to the signal is due to the failure of the components of the first hardware unit 720A, which is not in the signal path of the signal lines 699/702. It is therefore desirable to improve on this method of redundancy switching.

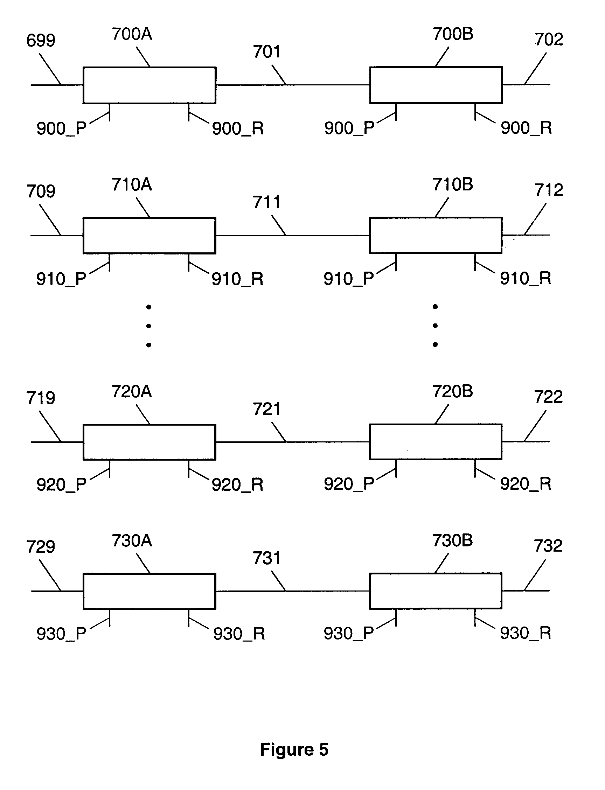

FIG. 5 illustrates a method of redundancy switching according to an example embodiment of the present invention. Other embodiments are also within the scope of the present invention. More specifically, FIG. 5 shows similar power control signals for two hardware units that are coupled in series. That is, two series coupled hardware units may be controlled together (i.e., simultaneously) based on one set of power control signals. This thereby avoids problems discussed above with respect to FIG. 4 as will be discussed below.

More specifically, FIG. 5 illustrates that the first hardware unit 700A and the second hardware unit 700B may both receive signals 900_P (for primary components) and 900_R (for redundant components) from the power control unit 660. Similarly, the first hardware unit 710A and the second hardware unit 710B may both receive signals 910_P (for primary components) and 910_R (for redundant components) from the power control unit 660. FIG. 5 also illustrates that the first hardware unit 720A and the second hardware unit 720B may both receive signals 920_P (for primary components) and 920_R (for redundant components) from the power control unit 660. The first hardware unit 730A and the second hardware unit 730B may both receive signals 930_P (for primary components) and 930_R (for redundant components) from the power control unit 660.

In the FIG. 5 arrangement, the power control unit 660 operates to apply the signal 900_R when any component in either the first hardware unit 700A or the second hardware unit 700B fails or is in danger of failing. The power control unit 660 also operates to apply the signal 910_R when any component in either the first hardware unit 710A or the second hardware unit 710B fails or is in danger of failing. The power control unit 660 operates to apply the signal 920_R when any component in either the first hardware unit 720A or the second hardware unit 720B fails or is in danger of failing. Additionally, the power control unit 660 operates to apply the signal 930_R when any component in either the first hardware unit 730A or the second hardware unit 730B fails or is in danger of failing. By operating the series coupled hardware units with similar power control signals, problems of the FIG. 4 arrangement may be avoided. That is, when a component fails in the first hardware unit 700A, then the power control unit 660 applies the signal 900_R to switch to the redundant components. Thus, any signals passing through any other signal path, such as along signal lines 709, 719, 729 will not be interrupted while switching the first hardware unit 700A and the second hardware unit 700B to the redundant components. Thus, these hardware units are switched to the redundant components. This thereby does not require the large number of power control signals to control all the hardware units (as in the FIG. 3 arrangement) and does not needlessly interrupt the signal for perfectly working hardware in a signal path (as in the FIG. 4 arrangement).

Accordingly, embodiments have been described with respect to combining two or more serial hardware units into a single string so that the serial hardware units may be switched simultaneously via control signals generated in a power control unit. Embodiments of the present invention may simultaneously switch the serial primary hardware units to the redundant hardware units so that only one set of control input lines may be needed. This may allow a lower cost implementation for power converter switching designs upon primary unit failure to a redundant unit because the control lines are applied throughout the series primary hardware units or both the series redundant hardware units.

Any reference in the above description to "one embodiment", "an embodiment", "example embodiment", etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the knowledge of one skilled in the art to effect such feature, structure, or characteristic in connection with other ones of the embodiments.

Although the present invention has been described with reference to a number of illustrative embodiments thereof, it should be understood that numerous other modifications and embodiments can be devised by those skilled in the art that will fall within the spirit and scope of the principles of this invention. More particularly, reasonable variations and modifications are possible in the component parts and/or arrangements of the subject combination arrangement within the scope of the foregoing disclosure, the drawings and the appended claims without departing from the spirit of the invention. In addition to variations and modifications in the component parts and/or arrangements, alternative uses will also be apparent to those skilled in the art.

## Claims

1. A redundancy network in a spacecraft payload comprising:
a first unit having first unit primary components and first unit redundant components; and
a second unit, coupled in series to said first unit, and having second unit primary components and second unit redundant components, wherein a signal passes through said first unit primary components and through said second unit primary components based on a first control signal and passes through said first unit redundant component and through said second unit redundant component based on a second control signal.

2. The redundancy network of claim 1, further comprising:
a third unit having third unit primary components and third unit redundant components; and
a fourth unit, coupled in series to said third unit, and having fourth unit primary components and fourth unit redundant components, wherein a signal passes through said third unit primary components and through said fourth unit primary components based on a third control signal and passes through said third unit redundant components and through said fourth unit redundant components based on a fourth control signal.

3. The redundancy network of claim 2, wherein said first unit and said third unit perform substantially similar functions, and wherein said second unit and said fourth unit perform substantially similar functions.

4. A satellite communications payload comprising:
a first unit having first primary components between an input terminal and an output terminal, and first redundant components between said input terminal and said output terminal;
a second unit, coupled in series to said first unit, said second unit having second primary components between an input terminal and an output terminal, and second redundant components between said input terminal and said output terminal; and
a power control unit to apply a first signal to said first unit to utilize said first redundant components and to apply said first signal to said second unit to utilize said second redundant components.

5. The satellite of claim 4, further comprising:
a third unit, coupled in parallel to said first unit, said third unit having third primary components between an input terminal and an output terminal, and third redundant components between said input terminal and said output terminal; and
a fourth unit, coupled in series to said third unit and in parallel to said second unit, said fourth unit having fourth primary components between an input terminal and an output terminal, and fourth redundant components between said input terminal and said output terminal, wherein said power control unit applies a second signal to said third unit to utilize said third redundant components and applies said second signal to said fourth unit to utilize said fourth redundant components.

6. The satellite of clam 4, wherein said power control unit applies said first signal when a failure occurs to one of said first primary components and said second primary components.

7. A method comprising:
monitoring status of components within a first unit and components of a second unit, said second unit coupled in series with said first unit;
applying a first control signal to said first unit such that signals pass through redundant components of said first unit based on said monitored status; and
applying said first control signal to said second unit such that signals pass through redundant components of said second unit based on said monitored status.

8. The method of claim 7, further comprising:
monitoring status of components within a third unit and components of a fourth unit, said third unit coupled in series with said fourth unit and in parallel with said first unit;
applying a second control signal to said third unit such that signals pass through redundant components of said third unit based on said monitored status; and
applying said second control signal to said fourth unit such that signals pass through redundant components of said fourth unit based on said monitored status.

9. The method of claim 7, wherein said first control signal comprises a power control signal for said redundant components of said first unit and said second unit.

10. The method of claim 7, wherein said monitoring and applying of said first control signal is provided within a payload of a satellite.
